# EUROPEAN PATENT APPLICATION

(11) **EP 3 112 432 A1**
(43) Date of publication of application: **04.01.2017**
(21) Application number: 15755777.8
(22) Date of filing: 23.02.2015
(51) Int. Cl.: C09J 123/22, B32B 27/18, B32B 27/30, B32B 27/32, C09J 4/06, C09J 7/00, C09J 7/02, C09J 11/08

(54) **ADHESIVE COMPOSITION, ADHESIVE SHEET, AND ELECTRONIC DEVICE**

(30) Priority: 25.02.2014 JP 2014034158
(71) Applicant: LINTEC Corporation, Tokyo 173-0001 (JP)
(72) Inventor: NISHIJIMA, Kenta, Tokyo 173-0001 (JP); MORI, Yuichi, Tokyo 173-0001 (JP); HAGIHARA, Yoshiaki, Tokyo 173-0001 (JP)
(74) Representative: Adam, Holger
(86) International application number: PCT/JP2015/055042
(87) International publication number: WO 2015/129625

(57) **Abstract**

The present invention is an adhesive composition including a Polyisobutylene-based resin (A), an energy ray-curable resin (B), and a tackifier (C),
the energy ray-curable resin (B) including a difunctional acrylate that includes a divalent alicyclic hydrocarbon group,
the adhesive composition including the energy ray-curable resin (B) in a ratio of 5 to 59 parts by mass based on 100 parts by mass of the Polyisobutylene-based resin (A), and including the tackifier (C) in a ratio of 0.1 to 40 parts by mass based on 100 parts by mass of the Polyisobutylene-based resin (A); and
an adhesive sheet including a release sheet, and an adhesive layer that is formed on the release sheet,
the adhesive layer being formed using the adhesive composition; and
an electronic device including a transparent substrate, a device, and a sealing material, the sealing material being formed using the adhesive composition.

## Description

### TECHNICAL FIELD

The present invention relates to an adhesive composition that is useful as a material for forming an adhesive layer that exhibits an excellent water barrier capability and excellent adhesion, an adhesive sheet that includes an adhesive layer that is formed using the adhesive composition, and an electronic device that is sealed with the adhesive sheet.

### BACKGROUND ART

In recent years, an organic EL device has attracted attention as a light-emitting device that can emit light with high luminance through low-voltage DC drive.

However, the organic EL device has a problem in that the emission properties (e.g., luminance, luminous efficiency, and luminous uniformity) easily deteriorate with the passing of time.

It is considered that deterioration in emission properties occurs when oxygen, water, and the like enter the organic EL device, and cause the electrode and the organic layer to deteriorate. Several methods that utilize a sealing material have been proposed to solve this problem.

For example, Patent Literature 1 discloses an organic EL device having a configuration in which a photocurable resin layer (sealing material) having humidity resistance covers an organic EL layer that is provided on a glass substrate, and disposed between a transparent electrode and a bottom electrode that are formed in the shape of a thin film. Patent Literature 2 discloses a method that seals an organic EL device using a sealing film that is formed using a moisture-proof polymer film and an adhesive layer.

An acrylic-based adhesive and an acrylic-based pressure-sensitive adhesive (hereinafter referred to as "acrylic-based adhesive and the like") have been proposed as an adhesive and a pressure-sensitive adhesive that are used as the sealing material for the organic EL device, taking account of optical properties such as transparency.

For example, Patent Literature 3 discloses a UV-curable acrylic-based adhesive that can be cured at room temperature as a sealing material for an organic EL display.

Patent Literature 4 discloses an acrylic-based pressure-sensitive adhesive as a pressure-sensitive adhesive that can form a pressure-sensitive adhesive layer that allows light emitted from an organic EL display device to propagate to the surface of the display with an excellent propagation efficiency even after being heated.

However, a sealing material that is formed using the acrylic-based adhesive and the like has an insufficient water barrier capability, and is not satisfactory as to performance when used as a sealing material for which a very high water barrier capability is required (e.g., a sealing material for an organic EL device).

When a sealing material that is formed using the acrylic-based adhesive and the like has a cross-linked structure, the sealing material may be easily separated (delaminated) from the adherend due to an impact, vibrations, heat, or the like, and the water barrier capability may deteriorate to a large extent.

In recent years, an adhesive that includes a polyisobutylene-based resin has been proposed as a sealing adhesive that exhibits a good water barrier capability.

For example, Patent Literature 5 discloses an adhesive composition that is used as a sealing material for an organic EL display, and includes a specific hydrogenated cycloolefin-based polymer and a polyisobutylene resin.

### CITATION LIST

### PATENT LITERATURE

Patent Literature 1: JP-A-5-182759
Patent Literature 2: JP-A-5-101884
Patent Literature 3: JP-A-2004-87153
Patent Literature 4: JP-A-2004-224991
Patent Literature 5: JP-T-2009-524705 (WO2007/087281)
Patent Literature 6: JP-T-2011-526629 (US2011/0105637 A1)

### SUMMARY OF INVENTION

### TECHNICAL PROBLEM

A sealing material obtained using the adhesive composition disclosed in Patent Literature 5 that includes a polyisobutylene-based resin, and a sealing material obtained using the adhesive composition disclosed in Patent Literature 6 that includes a polyisobutylene-based resin and a polyfunctional (meth)acrylate monomer, exhibit a good water barrier capability as compared with a sealing material that utilizes an acrylic-based adhesive. However, these sealing materials exhibit an insufficient water barrier capability when used as a sealing material for an organic EL device. It is particularly important to prevent entry of water from the interface or the side of the sealing material when a significantly high water barrier capability is required (e.g., organic EL device). However, the sealing materials obtained using the known adhesion compositions are not satisfactory as to such performance. Moreover, Patent Literature 5 and 6 are silent about the properties of a film that is stacked on the sealing material. Patent Literature 6 refers to the total light transmittance of the adhesive composition, but is silent about the haze of the adhesive composition, and the adhesive composition may exhibit insufficient transparency when applied as a sealing material for an electronic device.

In order to solve the above problems, the applicant of the present application proposed an adhesive composition that includes an isobutylene-isoprene copolymer as the main component, wherein the content of a repeating unit derived from isoprene in the isobutylene-isoprene copolymer is 0.1 to 99 mol% (WO2014/084352 (PCT/JP2013/082173)). An adhesive sheet (adhesive sheet (A)) that includes an adhesive layer that is formed using the adhesive composition disclosed in WO2014/084352 exhibits an excellent water barrier capability, excellent transparency, and excellent adhesion, and may suitably be used as a sealing material for an electronic device.

However, since the adhesive layer of the adhesive sheet (A) does not exhibit sufficient holding power, voids may be formed with respect to the adhesive layer of the adhesive sheet (A) during storage and transportation, and a problem may occur when the adhesive sheet (A) is used as a sealing material for an electronic device, for example.

The invention was conceived in view of the above situation. An object of the invention is to provide an adhesive composition that can form an adhesive sheet (adhesive layer) that exhibits an excellent water barrier capability and excellent adhesion, shows only a low degree of haze, and exhibits excellent holding power, an adhesive sheet that includes an adhesive layer that is formed using the adhesive composition, and an electronic device that is sealed with the adhesive sheet.

### SOLUTION TO PROBLEM

The inventors conducted extensive studies in order to solve the above problem. As a result, the inventors found that an adhesive sheet that includes an adhesive layer that is formed using an adhesive composition that includes a Polyisobutylene resin (A), a specific energy ray-curable resin (B), and a tackifier (C) in a specific ratio, exhibits an excellent water barrier capability, excellent transparency, excellent adhesion, and excellent holding power. This finding has led to the completion of the invention.

Several aspects of the invention provide the following adhesive composition (see (1) to (3)), adhesive sheet (see (4) and (5)), and electronic device (see (6)).
(1) An adhesive composition including a Polyisobutylene resin (A), an energy ray-curable resin (B), and a tackifier (C), the energy ray-curable resin (B) including a difunctional acrylate that includes a divalent alicyclic hydrocarbon group, the adhesive composition including the energy ray-curable resin (B) in a ratio of 5 to 59 parts by mass based on 100 parts by mass of the Polyisobutylene resin (A), and including the tackifier (C) in a ratio of 0.1 to 40 parts by mass based on 100 parts by mass of the Polyisobutylene resin (A).
(2) The adhesive composition according to (1), further including a divalent linear difunctional acrylate (D).
(3) The adhesive composition according to (1), wherein the Polyisobutylene resin (A) is an isobutylene-isoprene copolymer.
(4) An adhesive sheet including a release sheet, and an adhesive layer that is formed on the release sheet, the adhesive layer being formed using the adhesive composition according to (1).
(5) An adhesive sheet including a base sheet, and an adhesive layer that is formed on the base sheet, the adhesive layer being formed using the adhesive composition according to (1).
(6) An electronic device including a transparent substrate, a device that is formed on the transparent substrate, and a sealing material that seals the device, the sealing material being formed using the adhesive composition according to (1).

### ADVANTAGEOUS EFFECTS OF INVENTION

The aspects of the invention thus provide an adhesive composition that can form an adhesive sheet (adhesive layer) that exhibits an excellent water barrier capability, excellent adhesion, and excellent holding power, an adhesive sheet that includes an adhesive layer that is formed using the adhesive composition, and an electronic device that includes a sealing material that is formed using the adhesive composition.

### DESCRIPTION OF EMBODIMENTS

An adhesive composition, an adhesive sheet, and an electronic device according to the exemplary embodiments of the invention are described in detail below.

### 1) Adhesive composition

An adhesive composition according to one embodiment of the invention includes a Polyisobutylene resin (A), an energy ray-curable resin (B), and a tackifier (C), the energy ray-curable resin (B) including a difunctional acrylate that includes a divalent alicyclic hydrocarbon group, the adhesive composition including the energy ray-curable resin (B) in a ratio of 5 to 59 parts by mass based on 100 parts by mass of the Polyisobutylene resin (A), and including the tackifier (C) in a ratio of 0.1 to 40 parts by mass based on 100 parts by mass of the Polyisobutylene resin (A).

### Polyisobutylene-based resin (A)

The Polyisobutylene-based resin (A) used in connection with one embodiment of the invention is a resin that includes a polyisobutylene skeleton in the main chain or the side chain, and includes a structural unit (a) shown below.

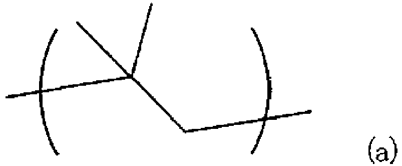

Examples of the Polyisobutylene-based resin (A) include polyisobutylene (isobutylene homopolymer), an isobutylene-isoprene copolymer, an isobutylene-n-butene copolymer, an isobutylene-butadiene copolymer, halogenated butyl rubbers obtained by brominating or chlorinating these copolymers, and the like. These resins may be used either alone or in combination.

Among these, an isobutylene-isoprene copolymer is preferable from the viewpoint of improving the durability and the weatherability of an adhesive layer that is formed using the adhesive composition according to one embodiment of the invention while decreasing the water vapor transmission rate of the adhesive layer.

The term "isobutylene-isoprene copolymer" used herein refers to a synthetic rubber that includes a repeating unit (-CH₂-C(CH₃)₂-) derived from isobutylene and a repeating unit (-CH₂-C(CH₃)=CH-CH₂-) derived from isoprene in the molecule.

The isobutylene-isoprene copolymer normally includes the repeating unit derived from isoprene in a ratio of 0.1 to 99 mol%, preferably 0.5 to 50 mol%, and more preferably 1 to 10 mol%, based on the total repeating units.

When the isobutylene-isoprene copolymer includes the repeating unit derived from isoprene in a ratio within the above range, it is possible to obtain an adhesive composition that exhibits an excellent water barrier capability.

The type of isobutylene-isoprene copolymer is not particularly limited. For example, the isobutylene-isoprene copolymer may be a recycled isobutylene-isoprene copolymer, a synthetic isobutylene-isoprene copolymer, or the like. It is preferable to use a synthetic isobutylene-isoprene copolymer.

The Polyisobutylene-based resin (A) may be synthesized using a method that polymerizes a monomer component such as isobutylene in the presence of a Lewis acid catalyst such as aluminum chloride or boron trifluoride.

A commercially-available product may be used as the Polyisobutylene resin (A). Examples of a commercially-available product that may be used as the Polyisobutylene resin (A) include Vistanex (manufactured by Exxon Chemical Co.), Hycar (manufactured by Goodrich), Oppanol (manufactured by BASF), and the like.

The number average molecular weight of the Polyisobutylene-based resin (A) is preferably 10,000 to 3,000,000, more preferably 100,000 to 2,000,000, and still more preferably 200,000 to 2,000,000. When the number average molecular weight of the Polyisobutylene-based resin (A) is within the above range, the adhesive composition has a moderate cohesive force (i.e., the cohesive force of the adhesive composition does not increase to a large extent), and a sufficient anchor effect can be obtained.

The content (on a solid basis) of the Polyisobutylene-based resin (A) in the adhesive composition is preferably 20 to 100 mass%, more preferably 30 to 100 mass%, and still more preferably 50 to 95 mass%. When the content of the rubber-based compound is within the above range, it is possible to form an adhesive layer that has a low water vapor transmission rate, exhibits excellent adhesion, and rarely shows interfacial separation.

### Energy ray-curable resin (B)

The adhesive composition according to one embodiment of the invention includes the energy ray-curable resin (B) in addition to the Polyisobutylene-based resin (A).

When the adhesive composition includes the energy ray-curable resin (B), it is possible to form an adhesive layer that exhibits an excellent water barrier capability, excellent transparency, excellent adhesion, and excellent holding power.

The energy ray-curable resin (B) used in connection with one embodiment of the invention is a resin that cures upon application of activated energy rays, and includes a difunctional acrylate that includes a divalent alicyclic hydrocarbon group (hereinafter may be referred to as "difunctional (meth)acrylate (B1)"). The term "(meth)acrylate" used herein refers to an acrylate or a methacrylate (hereinafter the same).

Since the difunctional (meth)acrylate (B1) includes a rigid alicyclic hydrocarbon group, it is possible to obtain an adhesive composition that has an improved cross-link density after being cured by application of energy rays, and exhibits excellent holding power.

The number of carbon atoms of the divalent alicyclic hydrocarbon group included in the difunctional acrylate (B1) is normally 3 to 30, and preferably 6 to 20. Specific examples of the divalent alicyclic hydrocarbon group include groups obtained by eliminating two hydrogen atoms from a monocyclic cycloalkane such as cyclopropane, cyclobutane, cyclopentane, and cyclohexane, a polycyclic cycloalkane such as norbornane, adamantane, tricyclodecane, and tetracyclododecane, a monocyclic cycloalkene such as cyclopropene, cyclobutene, cyclopentene, and cyclohexene, a polycyclic cycloalkene such as norbornene, tricyclodecene, and tetracyclododecene, and the like.

Specific examples of a preferable difunctional acrylate (B1) include a compound represented by the following formula (I). 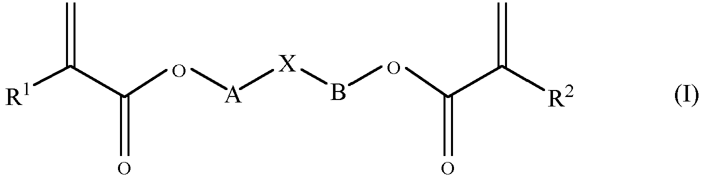 wherein X is a divalent alicyclic hydrocarbon group.

Specific examples of the alicyclic hydrocarbon group represented by X include those mentioned above. X is preferably a group obtained by eliminating two hydrogen atoms from a polycyclic cycloalkene (e.g., norbornene, tricyclodecene, or tetracyclododecene), and more preferably a group among the groups respectively represented by the following formulas (x-1) to (x-3).

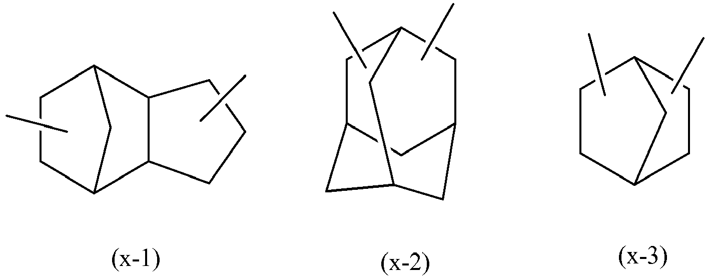

R¹ and R² are independently a hydrogen atom or an alkyl group having 1 to 6 carbon atoms.

Examples of the alkyl group having 1 to 6 carbon atoms that may be represented by R¹ and R² include a methyl group, an ethyl group, a propyl group, an isopropyl group, and the like. R¹ and R² are preferably independently a hydrogen atom or a methyl group.

A and B are independently a group represented by -[C(R³)(R⁴)]ₙ-. Note that R³ and R⁴ are a hydrogen atom, or an alkyl group having 1 to 6 carbon atoms (e.g., methyl group, ethyl group, propyl group, or isopropyl group). n is an integer from 1 to 10, and preferably an integer from 1 to 3.

Specific examples of the group represented by -[C(R³)(R⁴)]ₙ- include an alkylene group having 1 to 6 carbon atoms, such as a methylene group, an ethylene group, a propylene group, a trimethylene group, and a tetramethylene group.

The difunctional (meth)acrylate represented by the formula (I) is preferable, and the difunctional acrylate represented by the following formula (I-1) is particularly preferable as an activated energy ray-polymerizable monomer that includes two or more polymerizable unsaturated groups in the molecule.

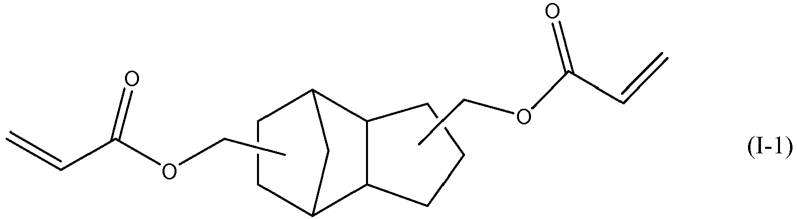

These difunctional acrylates (B1) may be used either alone or in combination.

It is preferable to use a linear difunctional (meth)acrylate (D) represented by the following formula (II) (hereinafter may be referred to as "difunctional (meth)acrylate (D)") in combination with the difunctional acrylate (B1).

When the difunctional (meth)acrylate (D) having a flexible chain is used in combination with the difunctional acrylate (B1), it is possible to improve compatibility with the Polyisobutylene-based resin (A), and obtain an adhesive composition that exhibits excellent transparency. 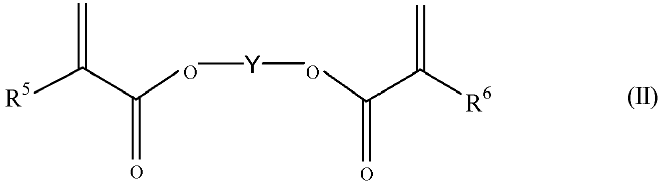 wherein Y is a group represented by -[C(R⁷)(R⁸)]ₘ- (wherein R⁷ and R⁸ are independently a hydrogen atom, or an alkyl group having 1 to 6 carbon atoms, and m is an integer from 1 to 10), and R⁵ and R⁶ are independently a hydrogen atom, or an alkyl group having 1 to 6 carbon atoms, provided that a plurality of groups represented by -[C(R⁷)(R⁸)]ₘ- are either identical or different when m is equal to or larger than 2.

Examples of the alkyl group having 1 to 6 carbon atoms that may be represented by R⁵ to R⁸ include a methyl group, an ethyl group, a propyl group, an isopropyl group, and the like. R⁵ to R⁸ are preferably independently a hydrogen atom or a methyl group.

When the difunctional (meth)acrylate (B1) and the difunctional (meth)acrylate (D) are used in combination, the difunctional (meth)acrylate (B1) and the difunctional (meth)acrylate (D) are used so that the mass ratio (difunctional (meth)acrylate (B1): difunctional (meth)acrylate (D)) of the difunctional (meth)acrylate (B1) to the difunctional (meth)acrylate (D) is 10:90 to 99:1, preferably 20:80 to 90:10, and more preferably 30:70 to 80:20.

When the difunctional (meth)acrylate (B1) and the difunctional (meth)acrylate (B2) are used in combination in a ratio within the above range, it is possible to obtain an adhesive composition that exhibits a further improved water barrier capability and adhesion, and exhibits excellent holding power.

A monofunctional (meth)acrylate, an energy ray-polymerizable monomer that includes two or more polymerizable unsaturated groups in the molecule (excluding the difunctional (meth)acrylate (B2)), and an energy ray-curable resin may also be used in combination with the difunctional (meth)acrylate (B1).

Examples of the monofunctional (meth)acrylate include (meth)acrylic acids such as acrylic acid, methacrylic acid, and crotonic acid; (meth)acrylic acid alkyl esters such as lauryl acrylate and 2-ethylhexyl acrylate; hydroxyl group-containing (meth)acrylic acid asters such as 2-hydroxyethyl acrylate, 2-hydroxypropyl acrylate, 4-hydroxybutyl acrylate, tetrahydrofurfuryl acrylate, and 1,6-hexanediol monoacrylate; and the like.

Examples of the energy ray-polymerizable monomer that includes two or more polymerizable unsaturated groups in the molecule include 1,4-butanediol di(meth)acrylate, 1,6-hexanediol di(meth)acrylate, neopentyl glycol di(meth)acrylate, polyethylene glycol di(meth)acrylate, neopentyl glycol adipate di(meth)acrylate, hydroxypivalic acid neopentyl glycol di(meth)acrylate, dicyclopentanyl di(meth)acrylate, caprolactone-modified dicyclopentenyl di(meth)acrylate, ethylene oxide-modified phosphoric acid di(meth)acrylate, allylated cyclohexyl di(meth)acrylate, isocyanurate di(meth)acrylate, trimethylolpropane tri(meth)acrylate, dipentaerythritol tri(meth)acrylate, propionic acid-modified dipentaerythritol tri(meth)acrylate, pentaerythritol tri(meth)acrylate, propylene oxide-modified trimethylolpropane tri(meth)acrylate, tris(acryloyloxyethyl) isocyanurate, propionic acid-modified dipentaerythritol penta(meth)acrylate, dipentaerythritol hexa(meth)acrylate, and caprolactone-modified dipentaerythritol hexa(meth)acrylate.

Examples of the energy ray-curable resin include a polyfunctional (meth)acrylate-based resin such as a urethane (meth)acrylate-based resin, a polyester (meth)acrylate-based resin, and an epoxy (meth)acrylate-based resin.

Examples of the urethane (meth)acrylate-based resin include a resin obtained by reacting a hydroxyl group-containing (meth)acrylate-based compound, a polyisocyanate-based compound, and a polyol-based compound, and the like.

Examples of the hydroxyl group-containing (meth)acrylate-based compound include a hydroxyalkyl (meth)acrylate such as 2-hydroxyethyl (meth)acrylate, 2-hydroxypropyl (meth)acrylate, 2-hydroxybutyl (meth)acrylate, 4-hydroxybutyl (meth)acrylate, and 6-hydroxyhexyl (meth)acrylate, 2-hydroxyethylacryloyl phosphate, 2-(meth)acryloyloxyethyl-2-hydroxypropyl phthalate, a caprolactone-modified 2-hydroxyethyl (meth)acrylate, dipropylene glycol (meth)acrylate, a fatty acid-modified glycidyl (meth)acrylate, polyethylene glycol mono(meth)acrylate, polypropylene glycol mono(meth)acrylate, 2-hydroxy-3-(meth)acryloyloxypropyl (meth)acrylate, glycerol di(meth)acrylate, 2-hydroxy-3-acryloyloxypropyl methacrylate, pentaerythritol tri(meth)acrylate, a caprolactone-modified pentaerythritol tri(meth)acrylate, an ethylene oxide-modified pentaerythritol tri(meth)acrylate, dipentaerythritol penta(meth)acrylate, a caprolactone-modified dipentaerythritol penta(meth)acrylate, an ethylene oxide-modified dipentaerythritol penta(meth)acrylate, and the like.

Examples of the polyisocyanate-based compound include an aromatic polyisocyanate such as tolylene diisocyanate, diphenylmethane diisocyanate, polyphenylmethane polyisocyanate, a modified diphenylmethane diisocyanate, xylylene diisocyanate, tetramethylxylylene diisocyanate, phenylene diisocyanate, and naphthalene diisocyanate; an aliphatic polyisocyanate such as hexamethylene diisocyanate, trimethylhexamethylene diisocyanate, lysine diisocyanate, and lysine triisocyanate; an alicyclic polyisocyanate such as a hydrogenated diphenylmethane diisocyanate, a hydrogenated xylylene diisocyanate, isophorone diisocyanate, norbornene diisocyanate, and 1,3-bis(isocyanatomethyl)cyclohexane; a trimer compound or a multimer compound of these polyisocyanates; an allophanate-type polyisocyanate; a biuret-type polyisocyanate; a water-dispersion-type polyisocyanate (e.g., Aquanate 100, Aquanate 110, Aquanate 200, and Aquanate 210 manufactured by Nippon Polyurethane Industry Co., Ltd.); and the like.

Examples of the polyol-based compound include a polyether polyol such as an alkylene structure-containing polyether polyol such as polyethylene glycol, polypropylene glycol, polytetramethylene glycol, polybutylene glycol, and polyhexamethylene glycol; a polyester polyol such as a reaction product of a polyhydric alcohol such as ethylene glycol or diethylene glycol, a polycarboxylic acid such as malonic acid, maleic acid, or fumaric acid, and a cyclic ester such as propiolactone, β-methyl-δ-valerolactone, or epsilon-caprolactone; a polycarbonate-based polyol such as a reaction product of a polyhydric alcohol and phosgene, and a ring-opening polymer of a cyclic carbonic ester (e.g., an alkylene carbonate such as ethylene carbonate, trimethylene carbonate, tetramethylene carbonate, or hexamethylene carbonate); a polyolefin-based polyol such as a polyolefin-based polyol that includes a homopolymer or a copolymer of ethylene, propylene, butene, or the like as a saturated hydrocarbon skeleton, and includes a hydroxyl group at the molecular terminal; a polybutadiene-based polyol such as a polybutadiene-based polyol that includes a copolymer of butadiene as a hydrocarbon skeleton, and includes a hydroxyl group at the molecular terminal; a (meth)acrylic-based polyol such as a (meth)acrylic-based polyol that includes at least two hydroxyl groups in the molecule of a polymer or a copolymer of a (meth)acrylate such as methyl (meth)acrylate, ethyl (meth)acrylate, propyl (meth)acrylate, butyl (meth)acrylate, or 2-ethylhexyl (meth)acrylate; a polysiloxane-based polyol such as dimethylpolysiloxane polyol and methylphenylpolysiloxane polyol; and the like.

Examples of a commercially-available product that may be used as the urethane (meth)acrylate-based resin include SHIKOH UT-4690 and SHIKOH UT-4692 (manufactured by Nippon Synthetic Chemical Industry Co., Ltd.); and the like.

Examples of the polyester (meth)acrylate-based resin include a compound obtained by esterifying the hydroxyl groups of a polyester oligomer having a hydroxyl group at each terminal with (meth)acrylic acid, the polyester oligomer being obtained by dehydration and condensation of a polybasic carboxylic acid (anhydride) and a polyol; a compound obtained by esterifying the terminal hydroxyl group of an oligomer with (meth)acrylic acid, the oligomer being obtained by adding an alkylene oxide to a polycarboxylic acid; and the like.

Examples of the polybasic carboxylic acid (anhydride) used to produce the polyester (meth)acrylate-based resin include succinic acid (anhydride), adipic acid, maleic acid (anhydride), itaconic acid (anhydride), trimellitic acid (anhydride), pyromellitic acid (anhydride), hexahydrophthalic acid (anhydride), phthalic acid (anhydride), isophthalic acid, terephthalic acid, and the like. Examples of the polyol include 1,4-butanediol, 1,6-hexanediol, diethylene glycol, triethylene glycol, propylene glycol, dimethylolheptane, trimethylolpropane, pentaerythritol, dipentaerythritol, and the like.

Examples of the epoxy (meth)acrylate-based resin include a compound obtained by reacting (meth)acrylic acid with the oxirane ring of a bisphenol-type epoxy resin or a novo lac-type epoxy resin having a relatively low molecular weight to effect esterification, and the like.

A commercially-available product may be used directly as these compounds.

When UV rays are used as the energy rays, a photocurable resin composition that normally includes a photoinitiator together with the difunctional (meth)acrylate (B1) is used as the energy ray-curable resin (B). When electron beams are used as the energy rays, it is unnecessary to use a photoinitiator.

It is preferable to use activated rays such as UV rays as the activated energy rays from the viewpoint of operability and the like. Therefore, it is preferable to use a photocurable resin composition that includes the difunctional (meth)acrylate (B1) and a photoinitiator as the energy ray-curable resin (B) used in connection with one embodiment of the invention.

Examples of the photoinitiator include benzoin, benzoin methyl ether, benzoin ethyl ether, benzoin isopropyl ether, benzoin n-butyl ether, benzoin isobutyl ether, acetophenone, dimethylaminoacetophenone, 2,2-dimethoxy-2-phenylacetophenone, 2,2-diethoxy-2-phenylacetophenone, 2-hydroxy-2-methyl-1-phenylpropan-1-one, 1-hydroxycyclohexyl phenyl ketone, 2-methyl-1-[4-(methylthio)phenyl]-2-morpholinopropan-1-one, 4-(2-hydroxyethoxy)phenyl 2-(hydroxyl-2-propyl) ketone, benzophenone, p-phenylbenzophenone, 4,4'-diethylaminobenzophenone, dichlorobenzophenone, 2-methylanthraquinone, 2-ethylanthraquinone, 2-t-butylanthraquinone, 2-aminoanthraquinone, 2-methylthioxanthone, 2-ethylthioxanethone, 2-chlorothioxanthone, 2,4-dimethylthioxanethone, 2,4-diethylthioxanthone, benzyl dimethyl ketal, acetophenone dimethyl ketal, a p-dimethylaminobenzoate, and the like.

Examples of the photoinitiator that is used for a cationically photopolymerizable oligomer include a compound that includes an onium ion (e.g., aromatic sulfonium ion, aromatic oxosulfonium ion, or aromatic iodonium ion) and an anion (e.g., tetrafluoroborate, hexafluorophosphate, hexafluoroantimonate, or hexafluoroarsenate), and the like.

These photoinitiators may be used either alone or in combination.

The photoinitiator is normally used in a ratio of 0.2 to 10 parts by mass based on 100 parts by mass of the activated energy ray-polymerizable monomer and/or the activated energy ray-curable resin.

The energy ray-curable resin (B) is normally used in a ratio of 5 to 59 parts by mass, preferably 10 to 39 parts by mass, and still more preferably 10 to 35 parts by mass, based on 100 parts by mass of the Polyisobutylene-based resin (A).

When the energy ray-curable resin (B) is used in a ratio of 5 parts by mass or more based on 100 parts by mass of the Polyisobutylene-based resin (A), it is possible to efficiently form an adhesive layer that exhibits further improved holding power. When the energy ray-curable resin (B) is used in a ratio of 59 parts by mass or less based on 100 parts by mass of the Polyisobutylene-based resin (A), it is possible to prevent a situation in which the adhesion of the adhesive layer decreases.

### Tackifier (C)

The adhesive composition according to one embodiment of the invention includes the tackifier (C) in addition to the Polyisobutylene-based resin (A) and the energy ray-curable resin (B).

When the adhesive composition includes the tackifier (C), it is possible to obtain an adhesive composition that is useful for forming an adhesive layer that exhibits a further improved water barrier capability and further improved adhesion.

The tackifier (C) is not particularly limited as long as the tackifier (C) improves the adhesion of the adhesive layer. A known material may be used as the tackifier (C). Examples of the tackifier (C) include an alicyclic petroleum resin, an aliphatic petroleum resin, a terpene resin, an ester-based resin, a coumarone-indene resin, a rosin-based resin, an epoxy resin, a phenol resin, an acrylic resin, a butyral resin, an olefin resin, a chlorinated olefin resin, a vinyl acetate resin, modified resins or hydrogenated resins thereof, and the like. Among these, an aliphatic petroleum resin, a terpene resin, a rosin ester-based resin, a rosin-based resin, and the like are preferable.

It is preferable to use a hydrogenated resin as the tackifier (C) since an adhesive layer that is rarely discolored even at a high temperature and a high humidity can be formed. The hydrogenated resin may be a partially hydrogenated product, or may be a completely hydrogenated product.

The weight average molecular weight of the tackifier (C) is preferably 100 to 10,000, and more preferably 500 to 5,000.

The softening point of the tackifier (C) is preferably 50 to 160°C, more preferably 60 to 140°C, and still more preferably 70 to 130°C.

A commercially-available product may be used directly as the tackifier (C). Examples of a commercially-available product that may be used as the tackifier (C) include an aliphatic petroleum resin such as ESCOREZ 1000 series products (manufactured by Exxon Chemical Co., Ltd.), and Quintone A/B/R/CX series products (manufactured by Zeon Corporation); an alicyclic petroleum resin such as ARKON P/M series products (manufactured by Arakawa Chemical Industries, Ltd.), ESCOREZ series products (manufactured by Exxon Chemical Co., Ltd.), EASTOTAC series products (manufactured by Eastman Chemical Company), and IMARV series products (manufactured by Idemitsu Kosan Co., Ltd.); a terpene-based resin such as YS Resin P/A series products (manufactured by Yasuhara Chemical Co., Ltd.), CLEARON P series products (manufactured by Yasuhara Chemical Co., Ltd.), and Piccolyte A/C series products (manufactured by Hercules); an ester-based resin such as Foral series products (manufactured by Hercules), Pensel A series products (manufactured by Arakawa Chemical Industries, Ltd.), Ester Gum series products (manufactured by Arakawa Chemical Industries, Ltd.), Super Ester series products (manufactured by Arakawa Chemical Industries, Ltd.), and Pinecrystal series products (manufactured by Arakawa Chemical Industries, Ltd.); and the like.

The tackifier (C) is normally used in a ratio of 0.1 to 40 parts by mass, and preferably 0.5 to 35 parts by mass, based on 100 parts by mass of the Polyisobutylene-based resin (A).

When the tackifier (C) is used in a ratio of 0.1 parts by mass or more based on 100 parts by mass of the Polyisobutylene-based resin (A), it is possible to efficiently form an adhesive layer that exhibits further improved adhesion. When the tackifier (C) is used in a ratio of 40 parts by mass or less based on 100 parts by mass of the Polyisobutylene-based resin (A), it is possible to prevent a situation in which the holding power of the adhesive layer decreases.

The adhesive composition (A) may include an additional component as long as the advantageous effects of the invention are not impaired. Examples of the additional component include additives such as a rubber-based polymer component, a silane coupling agent, an antistatic agent, a light stabilizer, an antioxidant, a UV absorber, a resin stabilizer, a filler, a pigment, an extender, and a softener.

These additional components may be used either alone or in combination.

Each additional component is preferably used in a ratio of 0.01 to 5 mass%, and more preferably 0.01 to 2 mass%, based on the adhesive composition.

The adhesive composition according to one embodiment of the invention may be prepared by appropriately mixing and stirring the Polyisobutylene-based resin (A), the energy ray-curable resin (B), the tackifier (C), an optional additional component, and an optional solvent using an ordinary method.

Examples of the solvent include an aromatic hydrocarbon-based solvent such as benzene and toluene; an ester-based solvent such as ethyl acetate and butyl acetate; a ketone-based solvent such as acetone, methyl ethyl ketone, and methyl isobutyl ketone; an aliphatic hydrocarbon-based solvent such as n-pentane, n-hexane, and n-heptane; an alicyclic hydrocarbon-based solvent such as cyclopentane and cyclohexane; and the like.

These solvents may be used either alone or in combination.

The solid content in the adhesive composition according to one embodiment of the invention is preferably 10 to 60 mass%, more preferably 10 to 45 mass%, and still more preferably 15 to 30 mass%.

An adhesive layer that is formed using the adhesive composition according to one embodiment of the invention exhibits excellent holding power when the holding power (at 70°C) of the adhesive layer is measured in accordance with JIS Z 0237.

An adhesive sheet that includes an adhesive layer that is formed using the adhesive composition according to one embodiment of the invention preferably has a holding power at 70°C measured in accordance with JIS Z 0237 of less than 10 mm, and more preferably less than 8 mm, in terms of the shift amount after 70,000 seconds has elapsed. If the shift amount after 70,000 seconds has elapsed is 10 mm or more (i.e., the holding power is insufficient), voids may be formed with respect to the adhesive layer during storage and transportation at a specific temperature (e.g., 70°C). The lower limit of the shift amount is normally 0.

An adhesive layer that is formed using the adhesive composition according to one embodiment of the invention preferably has a haze value (measured in accordance with JIS K 7105) of 5% or less. When the adhesive layer has a haze value of 5% or less, the adhesive layer exhibits significantly high transparency, and may suitably be applied to optical applications and the like.

An adhesive layer that is formed using the adhesive composition according to one embodiment of the invention preferably has a ratio "δ1/δ2" of 2.4 or less, δ1 being the loss tangent (tanδ) of the adhesive layer at 150°C, and δ2 being the loss tangent (tanδ) of the adhesive layer at 70°C.

The loss tangent (tanδ) is the ratio (G"/G') of the loss shear modulus (G") to the shear modulus (G'). The loss tangent (tanδ) is normally a parameter that represents the amount of energy absorbed by a material (i.e., the amount of energy converted into heat) when the material is deformed.

When the adhesive layer that is formed using the adhesive composition according to one embodiment of the invention has a ratio "δ1/δ2" of 2.4 or less (where, δ1 is the loss tangent (tanδ) of the adhesive layer at 150°C, and δ2 is the loss tangent (tanδ) of the adhesive layer at 70°C), an adhesive sheet that includes the adhesive layer that is formed using the adhesive composition according to one embodiment of the invention exhibits excellent holding power, and voids are not formed with respect to the adhesive layer during storage and transportation at a specific temperature (e.g., 70°C). If the ratio "δ1/δ2" exceeds 2.4, voids may be formed with respect to the adhesive layer during storage and transportation at a specific temperature (e.g., 70°C). The lower limit of the ratio "δ1/δ2" is normally 1, preferably 1.3 or more, more preferably 1.5 or more, and still more preferably 1.8 or more. The upper limit of the ratio "δ1/δ2" is preferably 2.3 or less, more preferably 2.2 or less, and still more preferably 2.0 or less.

The loss tangent (tanδ) of the adhesive layer at 70°C and the loss tangent (tanδ) of the adhesive layer at 150°C may be measured using a known dynamic viscoelastometer. More specifically, the loss tangent (tanδ) of the adhesive layer at 70°C and the loss tangent (tanδ) of the adhesive layer at 150°C may be measured using the method described herein in connection with the examples.

An adhesive composition that forms an adhesive layer that has a ratio "δ1/δ2" of 2.4 or less (where, δ1 is the loss tangent (tanδ) of the adhesive layer at 150°C, and δ2 is the loss tangent (tanδ) of the adhesive layer at 70°C) can be obtained by appropriately selecting the Polyisobutylene-based resin (A), the energy ray-curable resin (B), and the tackifier (C), and semi-empirically setting the ratio of the Polyisobutylene-based resin (A), the energy ray-curable resin (B), and the tackifier (C) to an appropriate value.

An adhesive layer that is formed using the adhesive composition according to one embodiment of the invention preferably has a storage modulus at 20 to 60°C of 10⁵ to 10⁶ Pa.

When the storage modulus of the adhesive layer is within the above range, the adhesive layer sufficiently adheres to a device formed on a transparent substrate, for example, and can more effectively suppress entry of water vapor.

The storage modulus of the adhesive layer may be measured using a known dynamic viscoelastometer.

An adhesive layer having a thickness of 20 µm that is formed using the adhesive composition according to one embodiment of the invention preferably has a water vapor transmission rate at a temperature of 40°C and a relative humidity of 90% of 60 g/m²/day or less, more preferably 55 g/m²/day or less, and still more preferably 50 g/m²/day or less.

The water vapor transmission rate of the adhesive layer may be measured using the method described herein in connection with the examples.

When the adhesive layer having a thickness of 20 µm that is formed using the adhesive composition has a water vapor transmission rate within the above range, the adhesive layer can more effectively suppress entry of water vapor when used as a sealing material for an electronic device.

Since the water vapor transmission rate of the adhesive layer depends on the thickness of the adhesive layer, the water vapor transmission rate of the adhesive layer is converted using the thickness of the adhesive layer when the thickness of the adhesive layer is not 20 µm. For example, when the thickness of the adhesive layer is A µm, and the water vapor transmission rate of the adhesive layer is B g/m²/day, the water vapor transmission rate of the adhesive layer at a thickness of 20 µm is calculated by the expression "A×B/20".

An adhesive layer that is formed using the adhesive composition according to one embodiment of the invention exhibits excellent adhesion.

An adhesive layer that is formed using the adhesive composition preferably has an adhesion to a glass substrate of 1 N/25 mm or more, more preferably 2 N/25 mm or more, still more preferably 3 N/25 mm or more, particularly preferably 5 N/25 mm or more, and most preferably 10 N/25 mm or more.

When the adhesion of the adhesive layer is within the above range, the adhesive layer sufficiently adheres to a transparent substrate, and can more effectively suppress entry of water vapor.

The adhesion of the adhesive layer may be measured using the method described herein in connection with the examples.

The adhesive composition according to one embodiment of the invention is also useful as a sealing material for a device formed on a transparent substrate, and a raw material for producing an adhesive sheet according to one embodiment of the invention (described below).

### 2) Adhesive sheet

An adhesive sheet according to one embodiment of the invention includes an adhesive layer that is formed using the adhesive composition according to one embodiment of the invention. Specific examples of the adhesive sheet according to one embodiment of the invention include an adhesive sheet (α) and an adhesive sheet (β) (see below).
Adhesive sheet (α): An adhesive including a release sheet, and an adhesive layer that is formed on the release sheet, the adhesive layer being formed using the adhesive composition according to one embodiment of the invention.
Adhesive sheet (β): An adhesive including a base sheet, and an adhesive layer that is formed on the base sheet, the adhesive layer being formed using the adhesive composition according to one embodiment of the invention.

### Adhesive layer

The adhesive layer included in the adhesive sheet (α) according to one embodiment of the invention and the adhesive layer included in the adhesive sheet (β) according to one embodiment of the invention are formed using the adhesive composition according to one embodiment of the invention. More specifically, the adhesive layer included in the adhesive sheet (α) and the adhesive layer included in the adhesive sheet (β) are formed by forming a film using the adhesive composition according to one embodiment of the invention, and drying and curing the resulting film.

The layer configuration of the adhesive sheet (α) according to one embodiment of the invention is not particularly limited as long as the adhesive sheet (α) includes at least the release sheet, and the adhesive layer that is formed on the release sheet. For example, the adhesive sheet (α) may have a layer configuration in which an adhesive layer is provided between two release sheets so that the adhesive layer comes in contact with the release-treated surface of each release sheet, or may have a layer configuration in which a plurality of layer structural units are stacked, each of the plurality of layer structural units including a release sheet, and an adhesive layer that is formed on the release sheet.

The release sheet included in the adhesive sheet is not particularly limited. For example, a release sheet that includes a base, and a release layer that is provided on the base and has been subjected to a release treatment using a release agent, may be used as the release sheet. When the adhesive sheet according to one embodiment of the invention includes two or more release sheets, the two or more release sheets may be formed of an identical material, or may be formed of different materials.

Examples of the base used to produce the release sheet include a paper base such as glassine paper, coated paper, and high-quality paper; laminated paper obtained by laminating a thermoplastic resin (e.g., polyethylene) on such a paper base; a plastic film formed of a polyethylene terephthalate resin, a polybutyrene terephthalate resin, a polyethylene naphthalate resin, a polypropylene resin, a polyethylene resin, or the like; and the like.

Examples of the release agent include a silicone-based resin, an olefin-based resin, a rubber-based elastomer (e.g., isoprene-based resin and butadiene-based resin), a long-chain alkyl-based resin, an alkyd-based resin, a fluorine-based resin, and the like.

The release sheet may be a double-sided release sheet in which the release layer is formed on each side of the base, or may be a single-sided release sheet in which the release layer is formed on one side of the base.

The thickness of the release sheet is not particularly limited, but is normally 20 to 200 µm, and preferably 25 to 150 µm.

The adhesive layer may be formed using an arbitrary method. For example, the adhesive layer may be formed by applying the adhesive composition according to one embodiment of the invention to the release-treated surface of the release sheet or a sealing substrate using a known method, and drying and curing the resulting film.

The adhesive composition may be applied using a spin coating method, a spray coating method, a bar coating method, a knife coating method, a roll coating method, a blade coating method, a die coating method, a gravure coating method, or the like.

The film is dried at 80 to 150°C for 30 seconds to 5 minutes, for example.

The film may be cured by applying activated energy rays to the film. In this case, activated energy rays may be applied after optionally placing a transparent release film on the surface of the film.

Examples of the activated energy rays include electron beams, UV rays, and the like. It is preferable to use UV rays as the activated energy rays. UV rays may be generated using a high-pressure mercury lamp, a fusion H lamp, a xenon lamp, or the like. The dose of the activated energy rays is appropriately selected taking account of the object. When using UV rays, the irradiance is preferably set to 50 to 1,000 mW/cm², and the dose is preferably set to 100 to 1,500 mJ/cm².

The thickness of the adhesive layer is not particularly limited, and may be appropriately selected taking account of the application. The thickness of the adhesive layer is preferably 0.5 to 200 µm, more preferably 1 to 100 µm, and still more preferably 5 to 80 µm. When the thickness of the adhesive layer is 0.5 µm or more, further improved adhesion can be easily obtained. When the thickness of the adhesive layer is 200 µm or less, it is possible to sufficiently block entry of water from the edge.

After forming the adhesive layer, the second release sheet is bonded to the adhesive layer so that the second release sheet is opposite to the release layer of the first release sheet through the adhesive layer to obtain the desired adhesive sheet.

The adhesive layer included in the adhesive sheet thus obtained exhibits an excellent water barrier capability, excellent adhesion, and excellent holding power. Therefore, when the adhesive layer is used as a sealing material, it is possible to sufficiently prevent entry of water. Moreover, voids are not formed in the adhesive layer even during storage and transportation at a specific temperature (e.g., 70°C).

Therefore, the adhesive sheet according to one embodiment of the invention may preferably be used to form a sealing material for an electronic device (described later). The adhesive sheet according to one embodiment of the invention is used as a sealing material for a device that can prevent a situation in which oxygen, water, and the like enter a device (e.g., organic EL device) formed on a transparent substrate, and cause an electrode and an organic layer to deteriorate.

The layer configuration of the adhesive sheet (β) according to one embodiment of the invention is not particularly limited as long as the adhesive sheet (β) includes the base sheet, and the adhesive layer that is formed on the base sheet, and the adhesive layer is formed using the adhesive composition according to one embodiment of the invention. For example, the adhesive sheet (β) according to one embodiment of the invention may further include a release sheet in addition to the base sheet and the adhesive layer formed on the base sheet.

A film or a sheet formed of a resin (e.g., polyimide, polyamide, polyamide-imide, polyphenylene ether, polyether ketone, polyether ether ketone, polyolefin, polyester, polycarbonate, polysulfone, polyether sulfone, polyphenylene sulfide, polyarylate, acrylic-based resin, cycloolefin-based polymer, aromatic polymer, or polyurethane-based polymer), a metal foil (e.g., aluminum foil), a laminate thereof, or the like may be used as the base sheet.

The thickness of the base sheet is not particularly limited, but is preferably 0.5 to 500 µm, more preferably 1 to 200 µm, and still more preferably 5 to 100 µm, from the viewpoint of ease of handling.

The base sheet may include a UV absorber, a light stabilizer, an antioxidant, an antistatic agent, a slipping agent, an antiblocking agent, a coloring agent, and the like. The surface of the base sheet may optionally be subjected to a surface treatment in order to improve adhesion between the base sheet and the curable adhesive layer.

A gas barrier layer may be formed on the base sheet either directly or through an additional layer in order to provide the base sheet with a gas barrier capability. The thickness of the gas barrier layer is not particularly limited, but is normally 10 to 2000 nm, preferably 20 to 1000 nm, more preferably 30 to 500 nm, and still more preferably 40 to 200 nm, from the viewpoint of gas barrier capability and handling capability.

The gas barrier layer may include a single layer, or may include a plurality of layers. It is preferable that the gas barrier layer include a plurality of layers since a higher gas barrier capability can be obtained.

A material for forming the gas barrier layer and the like are not particularly limited as long as it is possible to provide the gas barrier layer with the desired gas barrier capability.

It is preferable that the gas barrier layer have a water vapor transmission rate at a temperature of 40°C and a relative humidity of 90% (90%RH) of 0.1 g/m²/day or less, more preferably 0.05 g/m²/day or less, and still more preferably 0.005 g/m²/day or less.

When the gas barrier layer has a water vapor transmission rate at a temperature of 40°C and a relative humidity of 90% of 0.1 g/m²/day or less, it is possible to effectively suppress a situation in which oxygen, water, and the like enter a device (e.g., organic EL device) formed on a transparent substrate, and cause an electrode and an organic layer to deteriorate.

The gas (e.g., water vapor) transmission rate may be measured using a known gas transmission rate measurement device.

A material for forming the gas barrier layer and the like are not particularly limited as long as it is possible to provide the gas barrier layer with the desired gas barrier capability. Examples of the gas barrier layer include a gas barrier layer that is formed of an inorganic film, a gas barrier layer obtained by implanting ions into a layer that includes a polymer compound, and the like.

It is preferable that the gas barrier layer be a gas barrier layer that is formed of an inorganic film, or a gas barrier layer obtained by implanting ions into a layer that includes a polymer compound, since it is possible to efficiently form a thin layer that exhibits an excellent gas barrier capability.

The inorganic film is not particularly limited. Examples of the inorganic film include an inorganic deposited (evaporated) film.

Examples of the inorganic deposited film include an inorganic deposited film obtained by depositing an inorganic compound, and an inorganic deposited film obtained by depositing a metal.

Examples of the inorganic compound used as the raw material for forming the inorganic deposited film include an inorganic oxide such as silicon oxide, aluminum oxide, magnesium oxide, zinc oxide, indium oxide, and tin oxide; an inorganic nitride such as silicon nitride, aluminum nitride, and titanium nitride; an inorganic carbide; an inorganic sulfide; an inorganic oxynitride such as silicon oxynitride; an inorganic oxycarbide; an inorganic carbonitride; an inorganic oxycarbonitride; and the like.

Examples of the raw material for forming the metal deposited film include aluminum, magnesium, zinc, tin, and the like.

Examples of a polymer compound that is used when forming the gas barrier layer by implanting ions into a layer that includes a polymer compound (hereinafter may be referred to as "polymer layer") include a silicon-containing polymer compound (e.g., polyorganosiloxane and polysilazane-based compound), a polyimide, a polyamide, a polyamide-imide, a polyphenylene ether, a polyether ketone, a polyether ether ketone, a polyolefin, a polyester, a polycarbonate, a polysulfone, a polyether sulfone, a polyphenylene sulfide, a polyallylate, an acrylic-based resin, a cycloolefin-based polymer, an aromatic polymer, and the like. These polymer compounds may be used either alone or in combination.

Among these, a silicon-containing polymer compound is preferable, and a polysilazane-based compound is more preferable, since a gas barrier layer that exhibits an excellent gas barrier capability can be formed.

A product commercially available as a glass coating material or the like may be used directly as the polysilazane-based compound.

These polysilazane-based compounds may be used either alone or in combination.

The polymer layer may include an additional component other than the polymer compound as long as the object of the invention is not impaired. Examples of the additional component include a curing agent, an additional polymer, an aging preventive, a light stabilizer, a flame retardant, and the like.

The polymer layer may be formed by applying a layer-forming solution that includes at least one polymer compound, an optional additional component, a solvent, and the like using a known device (e.g., spin coater, knife coater, or gravure coater), and appropriately drying the resulting film, for example.

Examples of the ions that are implanted into the polymer layer include ions of a rare gas such as argon, helium, neon, krypton, and xenon; ions of a fluorocarbon, hydrogen, nitrogen, oxygen, carbon dioxide, chlorine, fluorine, sulfur, and the like; ions of alkane-based gases such as methane and ethane; ions of alkene-based gases such as ethylene and propylene; ions of alkadiene-based gases such as pentadiene and butadiene; ions of alkyne-based gases such as acetylene; ions of aromatic hydrocarbon-based gases such as benzene and toluene; ions of cycloalkane-based gases such as cyclopropane; ions of cycloalkene-based gases such as cyclopentene; ions of a metal; ions of an organosilicon compound; and the like.

These ions may be used either alone or in combination.

It is preferable to use ions of a rare gas such as argon, helium, neon, krypton, or xenon due to ease of ion implantation and a capability to form a gas barrier layer that exhibits a particularly excellent gas barrier capability.

The ions may be implanted using an arbitrary method. For example, the ions may be implanted by applying ions (ion beams) that are accelerated by applying an electric field, or implanting ions present in a plasma (plasma ion implantation method). It is preferable to use the plasma ion implantation method since a gas barrier layer can be easily obtained.

It is preferable that the base sheet be transparent. The total light transmittance of the base sheet is preferably 80% or more, and more preferably 85% or more.

When the base sheet has a total light transmittance of 80% or more, light incident on the device, or light emitted from the device is rarely blocked. Therefore, the adhesive sheet according to one embodiment of the invention can be used as a sealing material which is used for a device formed on a transparent substrate and for which transparency is required.

The total light transmittance of the base sheet may be measured using the method described herein in connection with the examples.

The adhesive sheet (β) according to one embodiment of the invention may further include an additional layer such as a protective layer, a conductive layer, and a primer layer, in addition to the gas barrier layer. These layers may be provided at an arbitrary position.

### 3) Electronic device

An electronic device according to one embodiment of the invention includes a transparent substrate, a device that is formed on the transparent substrate, and a sealing material that seals the device, the sealing material being formed using the adhesive composition according to one embodiment of the invention.

Examples of the electronic device include an organic device such as an organic transistor, an organic memory, and an organic EL device; a liquid crystal display; electronic paper; a thin film transistor; an electrochromic device; an electrochemical light-emitting device; a touch panel; a solar cell; a thermoelectric conversion device; a piezoelectric conversion device; an electrical storage device; and the like.

Examples of the device include a photoelectric conversion device such as a device that converts electrical energy into light (e.g., light-emitting diode and semiconductor laser), and a device that converts light into electrical energy (e.g., photodiode and solar cell); a light-emitting device such as an organic EL device; and the like.

The type, the size, the shape, the number, and the like of the device(s) formed on the transparent substrate are not particularly limited as long as the device can be sealed using the adhesive composition according to one embodiment of the invention.

The transparent substrate on which the device is formed is not particularly limited. Various substrate materials may be used. In particular, it is preferable to use a substrate material that exhibits high visible light transmittance. It is preferable to use a material that exhibits a high barrier capability that blocks entry of water and gas from the outside of the device, and also exhibits excellent solvent resistance and excellent weatherability. Specific examples of such a material include a transparent inorganic material such as quartz and glass; a transparent plastic such as polyethylene terephthalate, polyethylene naphthalate, polycarbonate, polystyrene, polyethylene, polypropylene, polyphenylene sulfide, polyvinylidene fluoride, acetyl cellulose, phenoxy bromide, aramids, polyimides, polystyrenes, polyarylates, polysulfones, and polyolefins; and the like.

The thickness of the transparent substrate is not particularly limited, and may be appropriately selected taking account of light transmittance and barrier capability.

A transparent conductive layer may be provided on the transparent substrate. The sheet resistance of the transparent conductive (electrode) layer is preferably 500 Ω/sq. or less, and more preferably 100 Ω/sq. or less.

A known material may be used as a material for forming the transparent conductive layer. Specific example of the material for forming the transparent conductive layer include indium tin oxide (ITO), fluorine-doped tin(IV) oxide (SnO₂) (FTO), tin(IV) oxide (SnO₂), zinc(II) oxide (ZnO), indium zinc oxide (IZO), and the like.

These materials may be used either alone or in combination.

The electronic device according to one embodiment of the invention may be produced in an arbitrary way as long as the device that is formed on the transparent substrate can be sealed by the sealing material that is formed using the adhesive composition according to one embodiment of the invention.

For example, the electronic device according to one embodiment of the invention may be produced as described below using the adhesive sheet (α) according to one embodiment of the invention. The adhesive sheet (α) according to one embodiment of the invention is provided. The adhesive layer of the adhesive sheet is bonded to the adherend (i.e., an optical device such as an organic EL device) so as to cover the adherend. The adhesive layer that exhibits excellent adhesion to the adherend and an excellent water barrier capability, and functions as a sealing material, can thus be provided on the surface of the adherend. After removing the release sheet, a sealing substrate is stacked on the exposed adhesive layer. The adhesive layer that exhibits excellent adhesion to the adherend and an excellent water barrier capability, and functions as a sealing material, can thus be provided on the surface of the adherend.

A known substrate such as a glass sheet or a plastic film may be used as the sealing substrate.

Examples of the plastic film include a film and a sheet formed of a resin (e.g., polyimide, polyamide, polyamide-imide, polyphenylene ether, polyether ketone, polyether ether ketone, polyolefin, polyester, polycarbonate, polysulfone, polyether sulfone, polyphenylene sulfide, polyarylate, acrylic-based resin, cycloolefin-based polymer, aromatic-based polymer, or polyurethane-based polymer).

The thickness of the sealing substrate is not particularly limited, but is preferably 0.5 to 500 µm, more preferably 1 to 200 µm, and still more preferably 5 to 100 µm, from the viewpoint of ease of handling.

The electronic device according to one embodiment of the invention may be produced as described below using the adhesive sheet (β) according to one embodiment of the invention. The adhesive sheet (β) according to one embodiment of the invention is provided. The adhesive layer of the adhesive sheet is bonded to the adherend (i.e., an optical device such as an organic EL device) so as to cover the adherend. The adhesive layer that exhibits excellent adhesion to the adherend and an excellent water barrier capability, and functions as a sealing material, can thus be provided on the surface of the adherend. In this case, it is preferable that the base sheet of the adhesive sheet (β) include a gas barrier layer. The electronic device according to one embodiment of the invention can be produced without using the sealing substrate by utilizing the adhesive sheet (β).

### EXAMPLES

The invention is further described below by way of examples. Note that the invention is not limited to the following examples.

The units "parts" and "%" used in connection with the examples respectively refer to "parts by mass" and "mass%" unless otherwise indicated.

The following compounds and materials were used in connection with the examples.

### (1) Polyisobutylene-based resin (A)

Isobutylene resin (A1): Exxon Butyl 268 manufactured by Japan Butyl Co., Ltd., isobutylene-isoprene copolymer, number average molecular weight: 260,000, isoprene content: 1.7 mol%

### (2) Energy ray-curable resin (B)

Energy ray-curable resin (b1): difunctional acrylate including divalent alicyclic hydrocarbon group (A-DCP manufactured by Shin-Nakamura Chemical Co., Ltd., tricyclodecanedimethanol di(meth)acrylate (i.e., a compound represented by the formula (I) wherein X is the group represented by the formula (x-1)))
Energy ray-curable resin (b2): trifunctional acrylate (A-9300 manufactured by Shin-Nakamura Chemical Co., Ltd.)

Energy ray-curable resin (b3): divalent linear difunctional acrylate (manufactured by Shin-Nakamura Chemical Co., Ltd.)

### (3) Tackifier (C1)

Aliphatic petroleum resin: Quintone A100 manufactured by Zeon Corporation,
softening point: 100°C
Photoinitiator: IRGACURE 500 manufactured by Ciba Specialty Chemicals, a mixture including benzophenone and 1-hydroxycyclohexyl phenyl ketone in a mass ratio of 1:1

### (4) Release sheet

Release sheet (1): polyethylene terephthalate film subjected to a silicone release treatment (SP-PET382150 manufactured by Lintec Corporation)
Release sheet (2): polyethylene terephthalate film subjected to a silicone release treatment (SP-PET381031 manufactured by Lintec Corporation)

### (5) Photoinitiator (D1)

IRGACURE 500 manufactured by Ciba Specialty Chemicals, a mixture including benzophenone and 1-hydroxycyclohexyl phenyl ketone in a mass ratio of 1:1

### Examples 1 to 15 and Comparative Examples 1 to 7

The isobutylene resin (A1) (100 parts), the energy ray-curable resin (B) (in the ratio shown in Table 1), the tackifier (C1) (in the ratio shown in Table 1), and the photoinitiator (D1) (10 parts) were dissolved in toluene to prepare an adhesive composition having a solid content of 17%.

The resulting adhesive composition was applied to the release-treated surface of the release sheet (1) so that the thickness after drying was 20 µm, and the resulting film was dried at 100°C for 2 minutes to form a resin layer. The release-treated surface of the release sheet (2) was then bonded to the resin layer. UV rays were applied to the resulting laminate through the release sheet (2) (dose: 200 mJ/cm², irradiance: 200 mW/cm²) to cure the resin layer to obtain an adhesive sheet including an adhesive layer.

### Adhesive sheet evaluation tests

The adhesive layer of the adhesive sheet (obtained in the examples and the comparative examples) was subjected to the following measurements.

### (1) Measurement of adhesion

The release sheet (1) was removed from the adhesive sheet (obtained in the examples and the comparative examples), and a polyethylene terephthalate film having a thickness of 25 µm was laminated on the exposed adhesive layer. The laminate was then cut to have a size of 25×200 mm. After removing the release sheet (2) from the laminate, the exposed adhesive layer was bonded to an adherend (glass sheet (soda lime glass) manufactured by Nippon Sheet Glass Co., Ltd.) at a temperature of 23°C and a relative humidity of 50%, and the adhesive sheet and the adherend were compression-bonded by reciprocating a roller having a weight of 2 kg by one stroke to obtain a specimen.

After allowing the specimen to stand at a temperature of 23°C and a relative humidity of 50% for 24 hours, the specimen was subjected to a peel test at a temperature of 23°C and a relative humidity of 50% using a tensile tester (Tensilon manufactured by Orientec Co., Ltd.) at a peel rate of 300 mm/min and a peel angle of 180° to measure the adhesion (N/25 mm) of the specimen.

### (2) Measurement of haze value

The haze value (%) of the adhesive layer of the adhesive sheet (obtained in the examples and the comparative examples) was measured in accordance with JIS K 7105 using a haze meter (NDH2000 manufactured by Nippon Denshoku Industries Co., Ltd.). The results are shown in Table 1.

### (3) Measurement of holding power at 70°C

The adhesive sheet (obtained in the examples and the comparative examples) was cut to have a size of 25×300 mm. After removing the release sheet (1), the exposed adhesive layer was bonded to a stainless steel sheet (SUS380) at a temperature of 23°C and a relative humidity of 50% so that the bonding area was 25×25 mm, and the adhesive sheet and the stainless steel sheet were compression-bonded by reciprocating a roller having a weight of 2 kg by five strokes to obtain a specimen.

The holding power of the adhesive sheet was measured in accordance with JIS Z 0237 (70°C, dry conditions, load: 9.8 N) using the resulting specimen to determine whether or not the adhesive sheet came off from the stainless steel sheet during a period of 70,000 seconds. In Table 1, "N.C." indicates that the adhesive sheet did not come off from the stainless steel sheet. Each value listed in Table 1 with respect to the holding power indicates the shift amount (mm) after 70,000 seconds had elapsed, and "Came off" indicates that the adhesive layer (adhesive sheet) came off from the stainless steel sheet.

### (4) Measurement of water vapor transmission rate

The release sheets (1) and (2) were removed from the adhesive sheet (obtained in the examples and the comparative examples), and the exposed adhesive layer was placed between two polyethylene terephthalate films (manufactured by Mitsubishi Plastics Inc., thickness: 6 µm) to obtain a water vapor transmission rate measurement sample. The water vapor transmission rate of the adhesive layer at a temperature of 40°C and a relative humidity of 90% was measured using a water vapor transmission rate measurement apparatus ("L80-5000" manufactured by LYSSY).

The water vapor transmission rate at a thickness of 20 µm was calculated from the measurement result as follows. The water vapor transmission rate at a thickness of 20 µm thus calculated is shown in Table 1.

When the thickness of the adhesive layer is A µm, and the water vapor transmission rate of the adhesive layer is B g/m²/day, the water vapor transmission rate of the adhesive layer at a thickness of 20 µm is calculated by the expression "A×B/20".

The measurement results for the water vapor transmission rate (g/m²/day), the adhesion (N/25mm), the haze value (%), and the holding power at 70°C are listed in Table 1.

**TABLE 1**

| | Polyisobutylene-based resin (A) | Energy ray-curable resin (B) | | | Tackifier (Cl) | Adhesion (N/25 mm) | Haze (%) | Holding power (70°C) | Water vapor transmission rate (g/m²/day) |
|---|---|---|---|---|---|---|---|---|---|
| | | b1 | b2 | b3 | | | | | |
| Example 1 | 100 | 15 | | | 1 | 4 | 1.9 | N.C. | 30.2 |
| Example 2 | 100 | 15 | | | 5 | 4.2 | 1.2 | 2 mm | 38.0 |
| Example 3 | 100 | 15 | | | 10 | 5.4 | 1.4 | N.C. | 37.5 |
| Example 4 | 100 | 15 | | | 20 | 5.6 | 1.2 | 3 mm | 48.7 |
| Example 5 | 100 | 20 | | | 1 | 4.9 | 4.3 | N.C. | 32.1 |
| Example 6 | 100 | 20 | | | 10 | 5.1 | 1.7 | 1 mm | 36.2 |
| Example 7 | 100 | 20 | | | 20 | 5.9 | 1.6 | 1 mm | 39.5 |
| Example 8 | 100 | 20 | | | 30 | 6.4 | 1.2 | 4 mm | 48.5 |
| Example 9 | 100 | 25 | | | 10 | 5.9 | 4.4 | N.C. | 31.2 |
| Example 10 | 100 | 25 | | | 20 | 5.7 | 1.7 | 1 mm | 36.4 |
| Example 11 | 100 | 30 | | | 25 | 6.6 | 4.0 | N.C. | 43.7 |
| Example 12 | 100 | 30 | | | 30 | 6.7 | 1.8 | N.C. | 41.2 |
| Example 13 | 100 | 30 | | | 35 | 7.1 | 1.8 | 6mm | 49.1 |
| Example 14 | 100 | 35 | | | 30 | 7.6 | 2.5 | N.C. | 40.2 |
| Example 15 | 100 | 10 | | 10 | 20 | 6.3 | 1.0 | 2 mm | 40.0 |
| Comparative Example 1 | 100 | | 20 | | 20 | 7.4 | 11.8 | 16 mm | 40.3 |
| Comparative Example 2 | 100 | | | 20 | 20 | 6.5 | 0.6 | Came off | 40.0 |
| Comparative Example 3 | 100 | | | | 20 | 10.7 | 1.2 | Came off | 25.5 |
| Comparative Example 4 | 100 | 3 | | | 20 | 9.2 | 1.3 | Came off | 38.5 |
| Comparative Example 5 | 100 | 60 | | | 20 | 0.1 | 13.5 | N.C. | 53.3 |
| Comparative Example 6 | 100 | 20 | | | 0 | 4.5 | 5.2 | N.C. | 29.8 |
| Comparative Example 7 | 100 | 20 | | | 50 | 6.8 | 1.9 | Came off | 55.3 |

As is clear from the results shown in Table 1, the adhesive sheets respectively including the adhesive layers formed using the adhesive compositions obtained in the examples exhibited an excellent water barrier capability, and exhibited transparency, adhesion, and holding power in a well-balanced manner, as compared with the adhesive sheets respectively including the adhesive layers formed using the adhesive compositions obtained in the comparative examples.

## Claims

1. An adhesive composition including a Polyisobutylene resin (A), an energy ray-curable resin (B), and a tackifier (C),
the energy ray-curable resin (B) including a difunctional acrylate that includes a divalent alicyclic hydrocarbon group,
the adhesive composition including the energy ray-curable resin (B) in a ratio of 5 to 59 parts by mass based on 100 parts by mass of the Polyisobutylene resin (A), and including the tackifier (C) in a ratio of 0.1 to 40 parts by mass based on 100 parts by mass of the Polyisobutylene resin (A).

2. The adhesive composition according to claim 1, further including a divalent linear difunctional acrylate (D).

3. The adhesive composition according to claim 1, wherein the Polyisobutylene resin (A) is an isobutylene-isoprene copolymer.

4. An adhesive sheet including a release sheet, and an adhesive layer that is formed on the release sheet,
the adhesive layer being formed using the adhesive composition according to claim 1.

5. An adhesive sheet including a base sheet, and an adhesive layer that is formed on the base sheet,
the adhesive layer being formed using the adhesive composition according to claim 1.

6. An electronic device including a transparent substrate, a device that is formed on the transparent substrate, and a sealing material that seals the device, the sealing material being formed using the adhesive composition according to claim 1.
